# EUROPÄISCHE PATENTSCHRIFT

(11) **EP 1 052 702 B1**
(45) Veröffentlichungstag und Bekanntmachung des Hinweises auf die Patenterteilung: **24.11.2010**
(21) Anmeldenummer: 00109198.2
(22) Anmeldetag: 09.05.2000
(51) Int. Cl.: H01L 31/032, H01L 31/0336, H01L 31/18

(54) **Dünnschichtsolarzelle auf der Basis der Ib/IIIa/VIa-Verbindungshalbleiter mit Potentialbarriere innerhalb der Absorberschicht und Verfahren zum Herstellen einer solchen Solarzelle**
Thin film Ib/IIIa/VIa compound semiconductor solar cell with potential barrier within the absorbing layer and method of production of such solar cell
Cellule solaire à couches minces à base du composé semiconducteur Ib/IIIa/VIa avec barrière de potentiel dans la couche d'absorption et méthode pour sa production

(30) Priorität: 10.05.1999 DE 19921514
(43) Veröffentlichungstag der Anmeldung: 15.11.2000
(73) Patentinhaber: ODERSUN Aktiengesellschaft, 15236 Frankfurt (Oder) (DE)
(72) Erfinder: Tober, Olaf, 10437 Berlin (DE); Penndorf, Jürgen, Dr., 15236 Hohenwalde (DE); Winkler, Michael, Dr., 12589 Berlin (DE); Jacobs, Klaus, Prof. Dr., 12559 Berlin (DE); Koschack, Thomas, Dr., 15295 Wiesenau (DE)
(74) Vertreter: Volpert, Marcus

(56) Entgegenhaltungen:
- EP-A2- 0 534 459
- WO-A-96/06454
- GB-A- 2 144 914
- JP-A- 7 211 927
- TUTTLE J R ET AL: "High efficiency thin-film Cu(In,Ga)Se2-based photovoltaic devices: progress towards a universal approach to absorber fabrication" PROCEEDINGS OF THE PHOTOVOLTAIC SPECIALISTS CONFERENCE. LOUISVILLE, MAY 10 - 14, 1993, NEW YORK, IEEE, US, Bd. CONF. 23, 10. Mai 1993 (1993-05-10), Seiten 415-421, XP010113370 ISBN: 0-7803-1220-1

## Beschreibung

Die Erfindung bezieht sich auf eine Dünnschichtsolarzelle nach dem Oberbegriff des Patentanspruchs 1 sowie auf ein Verfahren zum Herstellen einer solchen Solarzelle nach dem Oberbegriff des Patentanspruchs 6.

Eines der wesentlichen Ziele bei der Entwicklung von Photovoltaikmodulen ist die deutliche Reduktion der solaren Stromgestehungskosten. Solarzellen und Module auf der Basis von polykristallinen Ib/IIIa/VIa-Verbindungshalbleiter sind geeignete Kandidaten, um dieses Ziel zu erreichen. Insbesondere mit den Chalkopyriten auf der Basis von Kupfer, Indium und Gallium sowie Seien bzw. Schwefel, die allgemein als CIS bzw. CIGS bezeichnet werden, wurden in den letzten Jahren große Fortschritte erzielt.

Die Zellstruktur mit einer Molybdänrückelektrode, einer 1 bis 5 µm dicken polykristallinen Absorberschicht aus Cu(In,Ga)(Se,S)2 vom p-Leitungstyp und einer transparenten Frontelektrode als Kollektorschicht vom n-Leitungstyp bildet die Grundlage der meisten Solarzellen auf der Basis der Ib/IIIa/VIa-Verbindungshalbleiter. Die Potentialbarriere zur Trennung der lichterzeugten Ladungsträger bildet sich bei dieser Anordnung als Heteroübergang zwischen der pleitenden polykristallinen Absorberschicht und der n-leitenden Frontelektrode aus oder ist dieser unmittelbar benachbart.

In der DE-C2-196 34 580 wird eine andere Anordnung für eine Solarzelle auf der Basis der Ib/IIIa/VIa-Verbindungshalbleiter vorgeschlagen, nach der auf einem Kupferband eine polykristalline Absorberschicht aus Cu(In, Ga)(Se, S)₂ vom n-Leitungstyp abgeschieden wird. Darüber wird eine p-Ieitende Kollektorschicht aus Cu(S,O) aufgebracht. Wiederum fällt die Potentialbarriere zur Trennung der lichterzeugten Ladungsträger mit der Grenzfläche zwischen diesmal n-leitender Absorberschicht und der Kollektorschicht vom p-Leitungstyp zusammen oder ist dieser unmittelbar benachbart.

Beiden Anordnungen gemein ist die Ausbildung eines p/n-Überganges an der Grenzfläche zwischen polykristalliner Absorberschicht und der artfremden Kollektorschicht.

Nachteilig an diesen Anordnungen sind die im allgemeinen hohen Dichten von Ladungsträgereinfangzentren in den Heterogrenzflächen, welche durch Kontamination mit Fremdatomen, durch kristallographische Gitterdefekte infolge Gitterfehlanpassung, durch die Akkumulation von Punktdefekten und durch Banddiskontinuitäten entstehen. Diese Rekombinationszentren für Minoritätsladungsträger limitieren die photoelektrischen Wirkungsgrade solcher Heterosolarzellen entscheidend.

Ein Weg zur Verbesserung der Wirkungsgrade ist die Passiviening der Grenzflächenzustände durch die Abscheidung geeigneter dünner Bufferschichten zwischen die polykristalline Absorberschicht und die Kollektorschicht. Diese Bufferschichten vermindern die negativen Auswirkungen eines großen Unterschiedes in den Gitterkonstanten der polykristallinen Absorberschicht und der Ableitelektrode. Sie schützt die Absorberschicht vor Schäden beim Aufbringen der transparenten Frontelektrode. In der US-A-5 141 564 wird dazu die Abscheidung einer dünnen CdS-Schicht zwischen die p-leitende Absorber- und die n-leitende Kollektorschicht vorgeschlagen. In der DE-A1-44 40 878 wird eine Zwischenschicht aus In(OH, S) bzw. Zn(O, S) vorgestellt.

Eine andere Möglichkeit, Rekombinationen in der Raumladungszone zu vermeiden, ist die Konversion des Leitungstyps im oberflächennahen Bereich der polykristallinen Absorberschicht, so dass die Minoritäten die Heterogrenzfläche mit ihrer erhöhten Tragdichte nicht mehr erreichen können. In der EP-A1-0 817 279 wird eine oberflächennahe Dotierung der polykristallinen Absorberschicht mit VIIa-Elementen wie Chlor vorgeschlagen. In "Proceedings 2nd WCEPSC 1998, S. 545-548" wird eine Invertierung der oberflächennahen Bereiche der polykristallinen Absorberschicht durch den Einbau von IIb-Elementen wie Cadmium oder Va-Elementen wie Antimon vorgeschlagen.

Weitere konventionelle Dünnschichtsolarzellen sind aus WO 96/06454 und EP 0 534 459 bekannt.

Diese dünnen Schichten großflächig homogen zu reproduzieren, ist jedoch technisch nur schwer zu beherrschen und bedeutet zusätzlichen technologischen Aufwand. Die invertierten Bereiche tragen kaum zur Stromsammlung bei.

Der Erfindung hegt die Aufgabe zugrunde, eine Solarzelle der eingangs erwähnten Art auf der Basis der Ib/IIIa/VIa-Verbindungshalbleiter zu schaffen, deren n- und p-leitende Bereiche zur Ladungsträgergeneration beitragen und die kostengünstig großtechnisch hergestellt werden kann sowie ein Verfahren zum Herstellen einer solchen Solarzelle anzugeben.

Diese Aufgabe wird erfindungsgemäß durch eine Solarzelle mit den Merkmalen des Patentanspruchs 1 und durch ein Verfahren mit den Merkmalen des Patentanspruchs 6 gelöst. Vorteilhafte Weiterbildungen sind Gegenstand der jeweiligen Unteransprüche.

Grundlegende Idee der Erfindung ist es, eine Dünnschichtsolarzelle herzustellen, deren photoaktive polykristalline Absorberschicht aus einem heterogenen Gefüge zweier Ib/IIIa/VIa-Phasen (PAS I, PAS II), welche vertikal übereinander geschichtet sind, besteht, und eine Potentialbarriere im Volumen aufweist, wobei die Oberfläche der polykristallinen Absorberschicht vom p-Leitungstyp ist. Dazu werden erfindungsgemäß auf einem Substrat in einem ersten Schritt die Ib- und IIIa-Metalle abgeschieden, in einem zweiten Schritt in einem Chalkogenisierungsprozeß eine erste n-leitende Ib/IIIa/VIa-Phase erzeugt, in einem dritten Schritt auf der Oberfläche dieser Phase eine Ib/VIa-Phase abgeschieden, nachfolgend in einem Temperprozeß die erste Ib/IIIa/VIa-Phase mit der Ib/VIa-Phase teilweise zu einer zweiten Ib/IIIa/VIa-Phase, die an der Oberfläche p-leitend ist, umgewandelt, so dass die beiden die photoaktive Absorberschicht bildenden Ib/IIIa/VIa-Phasen vertikal übereinander geschichtet sind und sich innerhalb dieser eine Potentialbarriere ausbildet.

Besondere Vorteile erzielt die Erfindung bei der Nutzung von flexiblen, mechanisch festen Folien als Substrat. Bei der Nutzung solcher Substrate können die einzelnen Verfahrensschritte in kontinuierlichen Rolle-zu-Rolle Prozessen automatisiert durchgeführt werden. Der Herstellungsprozess solcher flexiblen Solarzellen ist hochproduktiv und aufgrund der geringen Wärmekapazität des Substrates sehr energieeffizient.

Die Erfindung wird nachfolgend anhand zweier Ausführungsbeispiele erläutert. In den zugehörigen Zeichnungen zeigen schematisch:

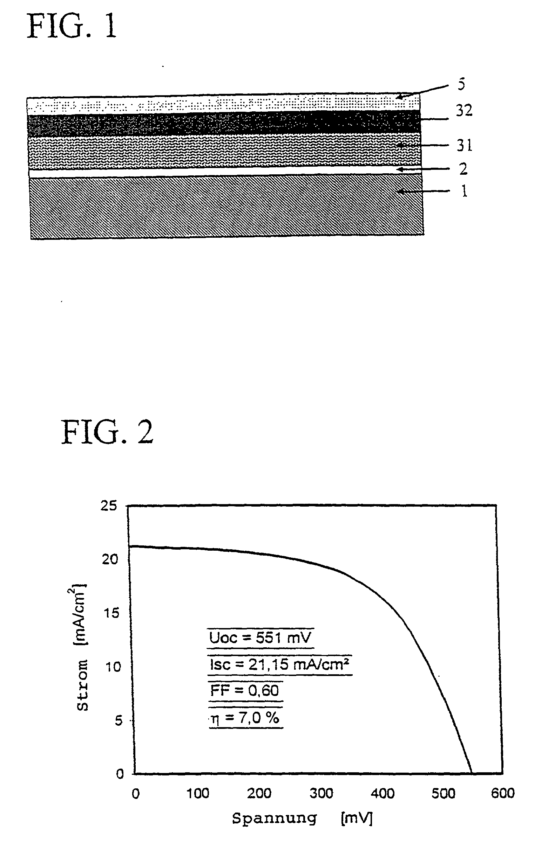

- Fig. 1: eine Struktur einer Solarzelle mit dem Substrat, der Rückelektrode, der polykristallinen Absorberschicht - bestehend aus den beiden ternären Phasen PAS I, PAS II- und einer transparenten Frontelektrode;
- Fig. 2: eine Kennlinie einer Struktur Cu₇In₃/CuIn₅S₈/CuInS₂/CUJ;

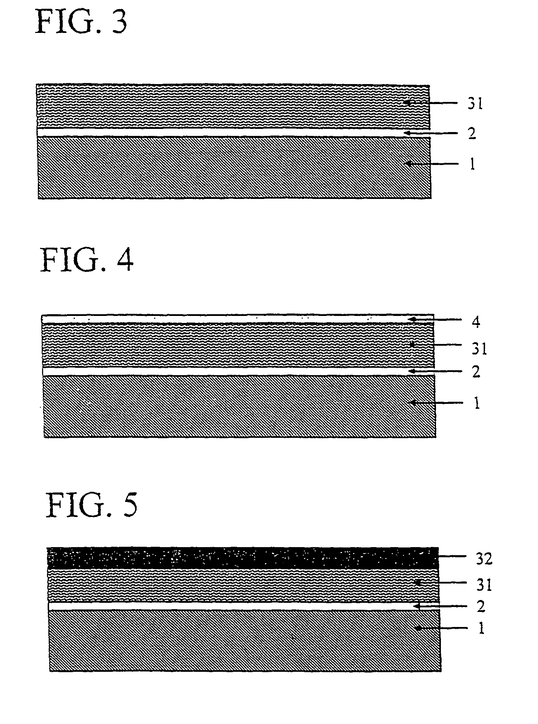

- Fig. 3: eine Struktur bestehend aus dem Substrat, der Rückelektrode und der ersten ternären Phase PAS I;
- Fig. 4: eine Struktur bestehend aus dem Substrat, der Rückelektrode, der ersten ternären Phase PAS I und einer Reaktionsschicht; und
- Fig. 5: eine Struktur des Bauelements mit dem Substrat, der Rückelektrode und der polykristallinen Absorberschicht, bestehend aus den beiden ternären Phasen PAS I, PAS II.

Die Solarzelle besteht aus einem Substrat 1, einer Rückelektrode 2, einer ersten ternären Phase (PAS I) 31 der polykristallinen Absorberschicht vom n-Leitungstyp, einer zweiten ternären Phase (PAS II) 32 der polykristallinen Absorberschicht, die an der Oberfläche vom p-Leitungstyp ist, so dass sich im Volumen der polykristallinen Absorberschicht die Potentialbarriere ausbildet, und einer transparenten Frontelektrode 5.

Als Substrat 1 dient üblicherweise eine dünne, typischerweise 10 µm bis 30 µm dicke Stahifolie, die zusätzlich mit anderen Metallen oder Oxiden beschichtet sein kann. Andere Folien können ebenfalls eingesetzt werden.

Auf dem Substrat 1 befindet sich eine 1 µm bis 5 µm dicke Rückelektrode 2 aus metallischen Phasen der Elemente Kupfer und Indium. Darüber ist die erste ternäre Phase 31 der polykristallinen Absorberschicht - aus der Phase CuIn₅S₈ bestehend - angeordnet. Diese stabile ternäre Phase 31 hat Spinellstruktur, ist vom n-Leitungstyp und besitzt bei Raumtemperatur eine für Solaranwendungen geeignete Bandlücke von 1,51 eV. Sie hat typischerweise eine Dicke von 0,5 µm bis 1 µm.

Unmittelbar auf der PAS I 31 befindet sich die zweite ternäre Phase 32 der polykristallinen Absorberschicht, die aus CuInS₂ besteht. Diese stabile ternäre Phase 32 hat Chalkopyritstruktur, kann durch Eigendotierung sowohl vom n-Leitungstyp als auch vom p-Leitungstyp sein und besitzt eine für Solaranwendungen geeignete Bandlücke.

Die ternäre Phase PAS II 32 ist typischerweise zwischen 0,1 µm und 1 µm dick. Die PAS II 32 ist an der Oberfläche vom p-Leitungstyp, so dass sich im Volumen der polykristallinen Absorberschicht die Potentialbarriere zur Trennung der lichterzeugten Ladungsträger ausbildet. Auf der polykristallinen Absorberschicht ist die transparente Ableitelektrode 5 angeordnet. Diese besteht vorzugsweise aus CuJ vom p-Leitungstyp mit einem geringen spezifischen Widerstand. Die Dicke der CuJ-Schicht beträgt typischerweise 0,5 µm bis 2 µm.

Eine weitere Möglichkeit ist die Anordnung einer transparenten Ableitelektrode 5 aus fremddotiertem ZnO vom n-Leitungstyp mit hoher spezifischer Leitfähigkeit auf der polykristallinen Absorberschicht mit Potentialbarriere. Diese Schicht hat typischerweise eine Dicke von 1 µm. Durch die quasi metallische Leitfähigkeit dieser TCO-Schicht bildet sich zwischen der polykristallinen Absorberschicht, die an der Grenzfläche zur Ableitelektrode vom p-Leitungstyp ist, und der Ableitelektrode vom n-Leitungstyp keine Potentialbarriere aus. In der Grenzfläche zwischen der dort p-leitenden polykristallinen Absorberschicht und dem TCO vom n-Leitungstyp entsteht eine Tunneldiode, die im Arbeitsbereich der Solarzelle eine ohmsche Charakteristik aufweist. Zwischen die polykristalline Absorberschicht mit Potentialbarriere und die Ableitelektrode vom n-Leitungstyp können dünne Bufferschichten vom p-Leitungstyp aus Cu₂O, Cu(S, O) oder CuS mit geringem spezifischen Widerstand angeordnet sein. Sie sind typischerweise 20 nm bis 50 mn dick.

Diese Bufferschichten dienen der Optimierung der Charakteristik der Tunneldiode zwischen der polykristallinen Absorberschicht mit Potentialbarriere und der hochleitfähigen Ableitelektrode.

Auf die flexible Folie, die das Substrat 1 der Solarzelle bildet, werden nacheinander in einem Rolle-zu-Rolle Prozess die Metalle Kupfer (Cu) und Indium (In) vorzugsweise elektrolytisch abgeschieden.

Dies ist ein sehr materialeffizientes und anlagentechnisch relativ einfaches Verfahren. Auch die Abscheidung der Metalle durch Sputter- und Vakuumverdampfungsprozesse oder Kombinationen dieser Prozesse sind möglich. Die Kupferschicht ist vorzugsweise 1 µm bis 5 µm dick, die Dicke der Indiumschicht beträgt typischerweise 0,5 µm bis 2 µm.

Danach wird die mit dem Cu/In-Precursor beschichtete Folie in einem Rolle-zu-Rolle Prozesse in einem Schmalspaltreaktor im Sekundenbereich chalkogenisiert. Der Precursor wird vorzugsweise im Millisekundenbereich auf 450 °C bis 550 °C unter Inertgasatmosphäre erhitzt. Das Indium schmilzt dabei auf, Kupfer wird laut Phasendiagranun in die Schmelze eingelöst.

Anschließend wird der Precursor in schwefelhaltigem Reaktionsgas, vorzugsweise in schwefelhaltigem Stickstoffträgergas chalkogenisiert. Die Chalkogenisierung dauert etwa 1 bis 3 Sekunden. Bei diesem Prozess wird eine typischerweise 1 µm bis 2 µm dicke CuIn₅S₈-Phase 31 gebildet. Diese stabile ternäre Phase 31 hat Spinellstruktur, ist n-leitend und besitzt bei Raumtemperatur eine für Solaranwendungen geeignete Bandlücke von 1,51 eV. Nach der Chalkogenisierung wird die Folie unter Inertgasatmosphäre im Sekundenbereich auf Raumtemperatur abgekühlt. Dabei erstarrt der Restprecursor unter Bildung von intermetallischen Cu/In-Phasen, vorzugsweise der Cu₇In₃-Phase, die die Rückelektrode 2 der Solarzelle bildet. Der gesamte Prozess "Aufheizung - Chalkogenisierung - Abkühlung" dauert typischerweise zwischen 3 s und 8 s.

In einem nächsten Schritt wird vorzugsweise in einem Rolle-zu-Rolle Prozess eine typischerweise 50 nm bis 200 nm dicke Schicht aus Kupfersulfid 4 abgeschieden, indem das Band zunächst in einem sogenannten Spin-on-Verfahren. einem Walzenauftragsverfahren oder einem Rakelauftragsverfahren oberflächlich mit einer Lösung aus Thioharnstoff und Kupferacetat beschichtet und nachfolgend getrocknet und formiert wird. Danach wird die mit Kupfersulfid 4 beschichtete polykristalline Absorberschicht 31 in einem Rolle-zu-Rolle Prozess getempert. Die beschichtete Folie wird dazu vorzugsweise im Millisekundenbereich durch Wärmeleitung auf 550 °C bis 600 °C unter Inertgasatmosphäre erhitzt.

Danach schließt sich ein Temperprozeß von 1 bis 10 s, vorzugsweise in Inertgasatmosphäre, an. Während dieses Temperprozesses reagieren die ternäre CuIn₅S₈-Phase und die binäre Kupfersulfid Phase teilweise miteinander zu einer ternären polykristallinen CuInS₂-Phase 32, die an der Oberfläche p-leitend ist. Die an der Oberfläche p-leitende polykristalline Absorberschicht 32 ist typischerweise 100 nm bis 500 nm dick. Die gesamte polykristalline Absorberschicht besteht nach der Temperung aus einem heterogenen Gefüge der Phasen CuIn₅S₈ 31 und CuInS₂ 32, die vertikal übereinander geschichtet sind, wobei die polykristalline Absorberschicht 31 vom n-Leitungstyp, die polykristalline Absorberschicht 32 an der Oberfläche vom p-Leitungstyp ist, und weist im Volumen eine Potentialbarriere zur Trennung der lichterzeugten Ladungsträger auf

Nach der Temperung wird die Folie im Sekundenbereich unter Inertgasatmosphäre auf Raumtemperatur abgekühlt. Der gesamte Prozess "Aufheizen - Tempern - Abkühlen" dauert vorzugsweise 3 s bis 15 s. In einem nachfolgenden Schritt kann die noch verbliebene Kupfersulfldschicht 4 ätztechnisch entfernt werden.

In einem letzten Schritt wird auf die polykristalline Absorberschicht 32 eine Frontelektrode 5 zur Abführung der Ladungsträger aufgebracht.

## Patentansprüche

1. Dünnschichtsolarzelle auf der Basis von Ib/IIIa/VIa-Verbindungshalbleitern,
mit einem Substrat (1) aus einer flexiblen Folie,
einer Rückelektrode (2) aus Cu und In, welche sich auf dem Substrat (1) befindet,
mit einer photoaktiven polykristallinen Absorberschicht aus einem heterogenen Gefüge von zwei Ib/IIIa/VIa-Phasen (31, 32), die vertikal übereinander geschichtet sind,
wobei die erste Phase (31) der polykristallinen Absorberschicht über der Rückelektrode (2) angeordnet und aus der ternären Phase CuIn₅S₈ vom n-Leitungstyp gebildet ist und
die zweite Phase (32) der polykristallinen Absorberschicht sich unmittelbar auf der ersten Phase (31) befindet, aus der ternären Phase CuInS₂ gebildet und an ihrer zur Licht einfallenden Seite weisenden Oberfläche vom p-Leitungstyp ist, so dass die Absorberschicht eine Potentialbarriere im Volumen aufweist.

2. Dünnschichtsolarzelle nach Anspruch 1, **dadurch gekennzeichnet, dass** sich auf der Oberfläche der Absorberschicht eine transparente Frontelektrode (5) befindet.

3. Dünnschichtsolarzelle nach Anspruch 2, **dadurch gekennzeichnet, dass** die Frontelektrode (5) aus CuJ vom p-Leitungstyp besteht.

4. Dünnschichtsolarzelle nach Anspruch 2, **dadurch gekennzeichnet, dass** die Frontelektrode (5) aus einer TCO-Schicht aus ZnO vom n-Leitungstyp mit hoher metallischer Leitfähigkeit besteht und dass in der Grenzfläche zwischen der dort p-leitenden Absorberschicht und der TCO-Schicht eine Tunnelelektrode ausgebildet ist.

5. Dünnschichtsolarzelle nach Anspruch 4, **dadurch gekennzeichnet, dass** zwischen der Absorberschicht und der Frontelektrode (5) dünne Pufferschichten vom p-Leitungstyp aus Cu₂O, Cu(S, O) oder CuS angeordnet sind.

6. Verfahren zum Herstellen einer Dünnschichtsolarzelle nach einem der vorhergehenden Ansprüche, **dadurch gekennzeichnet, dass**
- auf einem Substrat die Ib- und IIIa-Metalle Cu und In abgeschieden werden,
- in einem Chalkogenisierungsprozess eine erste Ib/IIIa/VIa-Phase (31) aus CuIn₅S₈ vom n-Leitungstyp erzeugt wird,
- auf der Oberfläche dieser Phase eine Ib/VIa-Phase aus Kupfersulfid abgeschieden wird,
- in einem Temperprozess die erste Ib/IIIa/VIa-Phase mit der Ib/VIa-Phase teilweise zu einer zweiten Ib/IIIa/VIa-Phase (32) aus CuInS₂ reagiert, die an ihrer Oberfläche vom p-Leitungstyp ist, so dass eine photoaktive polykristalline Absorberschicht eines heterogenen Gefüges von zwei Ib/IIIa/VIa-Phasen gebildet wird, die vertikal übereinander geschichtet sind und im Volumen die Potentialbarriere aufweisen.

7. Verfahren nach Anspruch 10 oder 11, **dadurch gekennzeichnet, dass** die Ib/VIa-Phase Cu₍₂₋ₓ₎S (0<x<1) ist.

## Claims

1. Thin-film solar cell based on Ib-IIIa-VIa compound semiconductors, having a substrate (1) made from a flexible foil, having a rear electrode (2) of Cu and In which is situated on the substrate (1), and having a photo-active polycrystalline absorber layer comprising a heterogeneous structure of two Ib-IIIa-VI phases (31, 32) which are layered one above the other vertically, wherein the first phase (31) of the polycrystalline absorber layer is arranged above the rear electrode (2) and is formed by the ternary phase CuIn₅S₈ having n-type conduction, and the second phase (32) of the polycrystalline absorber layer is situated directly on the first phase, is formed by the ternary phase CuInS₂, and has p-type conduction on its surface facing towards the incident-light side, thus causing the absorber layer to have a potential barrier within its volume.

2. Thin-film solar cell according to claim 1, **characterised in that** a transparent front electrode (5) is situated on the surface of the absorber layer.

3. Thin-film solar cell according to claim 2, **characterised in that** the front electrode (5) is composed of CuJ having p-type conduction.

4. Thin-film solar cell according to claim 2, **characterised in that** the front electrode (5) is composed of a TCO layer of ZnO of high metallic conductivity having n-type conduction, and **in that** a tunnel electrode is formed in the interface between the absorber layer, which has p-type conduction at that point, and the TCO layer.

5. Thin-film solar cell according to claim 4, **characterised in that** thin buffer layers of Cu₂O, Cu(S, O) or CuS, having p-type conduction, are arranged between the absorber layer and the front electrode (5).

6. Method of producing a thin-film solar cell according to one of the preceding claims, **characterised in that**
- the Ib and IIIa metals Cu and In are deposited on a substrate,
- a first Ib-IIIa-VIa phase (31) of CuIn₅S₈ having n-type conduction is formed in a chalkogenising process,
- there is deposited on the surface of this latter phase a Ib-VIa phase of copper sulphide,
- in a tempering process, the first Ib-IIIa-VIa phase partly reacts with the Ib-VIa phase to form a second Ib-IIIa-VIa phase (32) of CuInS₂, which has p-type conduction at its surface, thus causing a photo-active polycrystalline absorber layer to be formed comprising a heterogeneous structure of two Ib-IIIa-VIa phases which are layered one above the other vertically and which have the potential barrier within their volume.

7. Method according to claim 10 or 11, **characterised in that** the Ib-VIa phase is CU₍₂₋ₓ₎S(O<x<1).

## Revendications

1. Cellule solaire en couches minces à base de semi-conducteurs composites Ib/IIIa/VIa,
comprenant un substrat (1) à partir d'une feuille flexible,
une électrode postérieure (2) en Cu et In, qui se trouve sur le substrat (1),
comprenant une couche absorbante polycristalline photoactive formée d'une structure hétérogène de deux phases Ib/IIIa/VIa (31, 32) qui sont empilées verticalement l'une sur l'autre,
dans laquelle la première phase (31) de la couche absorbante polycristalline est agencée au-dessus de l'électrode postérieure (2) et est formée à partir de la phase ternaire CuIn₅S₈ d'un type de conduction n, et
la seconde phase (32) de la couche absorbante polycristalline se trouve immédiatement sur la première phase (31), est formée à partir de la phase ternaire CuInS₂ et présente un type de conduction p au niveau de sa surface tournée vers le côté de la lumière incidente, de sorte que la couche absorbante présente en volume une barrière de potentiel.

2. Cellule solaire en couches minces selon la revendication 1, **caractérisée en ce qu'**une électrode antérieure transparente (5) se trouve sur la surface de la couche absorbante.

3. Cellule solaire en couches minces selon la revendication 2, **caractérisée en ce que** l'électrode antérieure (5) est formée en CuJ d'un type de conduction p.

4. Cellule solaire en couches minces selon la revendication 2, **caractérisée en ce que** l'électrode antérieure (5) est formé d'une couche de TCO en ZnO d'un type de conduction n avec une forte conductivité métallique, et **en ce qu'**une électrode tunnel est réalisée dans la surface limitrophe entre la couche absorbante à conduction de type p à ce niveau et la couche TCO.

5. Cellule solaire en couches minces selon la revendication 4, **caractérisée en** en ce que des couches tampon minces de type de conduction p en Cu₂O, Cu(S, O) ou CuS sont agencées entre la couche absorbante et l'électrode antérieure (5).

6. Procédé pour la fabrication d'une cellule solaire en couches minces selon l'une des revendications précédentes, **caractérisée par** les étapes suivantes
- on dépose sur un substrat les métaux Cu et In de type Ib et IIIa,
- dans un processus de chalcogénisation, on produit une première phase Ib/IIIa/VIa (31) en CuIn₅S₈ de type de conduction n,
- sur la surface de cette phase on dépose une phase en sulfure de cuivre de type Ib/VIa,
- dans un processus de températion, la première phase Ib/IIIa/VIa réagit avec la phase Ib/VIa partiellement pour donner une seconde phase Ib/IIIa/VIa (32) en CuInS₂, qui est du type de conduction p à sa surface, de sorte qu'il se forme une couche absorbante polycristalline photoactive avec une structure hétérogène de deux phases Ib/IIIa/VIa, qui sont empilées verticalement l'une sur l'autre et présentent en volume la barrière de potentiel.

7. Procédé selon la revendication 5, **caractérisée en ce que** la phase Ib/VIa est du Cu₍₂₋ₓ₎S (0 < x < 1).
